# EUROPEAN PATENT SPECIFICATION

(11) **EP 2 415 334 B1**
(45) Date of publication and mention of the grant of the patent: **10.06.2015**
(21) Application number: 10719760.0
(22) Date of filing: 01.04.2010
(51) Int. Cl.: F28D 15/02, H05K 7/20

(54) **A REAR DOOR HEAT EXCHANGER AND A COOLING UNIT**
HINTERTÜRWÄRMETAUSCHER UND KÜHLEINHEIT
ECHANGEUR DE CHALEUR DE PORTE ARRIÈRE ET UNITÉ DE REFROIDISSEMENT

(30) Priority: 03.04.2009 GB 0905870
(43) Date of publication of application: 08.02.2012
(60) Divisional application: 15020059.0
(73) Proprietor: EATON-WILLIAMS GROUP LIMITED, Edenbridge Kent TN8 6EG (GB)
(72) Inventor: MUIR, Jeff, Hastings TN34 2EZ (GB); DIDYMIOTIS, Dion, London SW19 2DW (GB)
(74) Representative: Crouch, David John
(86) International application number: PCT/GB2010/000665
(87) International publication number: WO 2010/112873

(56) References cited:
- EP-A2- 1 298 975
- WO-A1-03/006910
- JP-A- 2002 022 313
- US-A- 5 725 049
- US-A1- 2006 232 945
- US-A1- 2010 101 765

## Description

Data centres are cooled by perimeter cooling, in which air to liquid heat exchangers are situated around the outside of the room and air is pumped from the interior of the data centre, down through the air to liquid heat exchangers, underneath the floor of the data centre, and from there upwards through air vents in the flooring into aisles between rows of blade racks. The cool air in these aisles passes by convection between the blades and out through to the other side of the row of racks, into a warm aisle. The warm air in the warm aisles passes by convection to the air above the racks, along the ceiling and then downwards once again through the air to liquid heat exchangers of the perimeter cooling. This cycle is continuous to keep the temperature of the centre at an acceptably low level for efficient operation of the blades.

With increasing operational capacity of the blades, an increasing amount of cooling of the air in the data centre becomes desirable or even necessary. Simply increasing the cooling capacity of the perimeter cooling is not necessarily an option because of limitation in the amount of cooling that can be effected in this way. This problem has been solved by attaching air to water heat exchangers at the rear of the racks, where the air flow exits from the racks. Such heat exchangers are referred to as rear door heat exchangers. They use water as the cooling medium because water has a relatively high specific heat compared to other coolants. The temperature of the water supplied to the rear door heat exchangers is about what would be considered normal room temperature or only slightly lower, typically in the region 18°C to 22°C. This is still effective because the air temperature where it exits the blades is higher, perhaps in the region of from 35°C to 45°C.

US 2006/232945 A1 discloses apparatus and a method for facilitating cooling of an electronics rack employing a heat exchanger assembly mounted to an outlet door cover hingedly affixed to an air outlet side of the rack. The heat exchanger assembly includes a support frame, and air-to-liquid heat exchanger, and first and second perforated planar surfaces covering first and second main sides, respectively, of the air-to-liquid heat exchanger. The heat exchanger is supported by the support frame and includes inlet and outlet plenums disposed adjacent to the edge of the outlet door cover hingedly mounted to the rack. Each plenum is in fluid communication with a respective connect coupling, and the heat exchanger further includes multiple horizontally-oriented heat exchange tube sections each having a serpentine cooling channel with an inlet and an outlet coupled to the inlet plenum and outlet plenum, respectively. Fins extend from the heat exchange tube sections.

WO 03/006910 A1 discloses a thermal bus for cabinets housing high-power electronics equipment that includes two spaced-apart horizontally oriented parallel evaporators interconnected in fluid communication with the condenser. Each evaporator is mounted in a support having a central recess and each having a tube having capillary wick disposed on an internal surface and being mounted within the central recess of the support. Each of the tubes includes a closed distal end and a closed proximal end with a liquid-working fluid entrance port located at the closed proximal end of the first tube and a vaporous-working fluid exit port located at the closed proximal end of the second tube. A duct defining central passageway and having a capillary wick disposed on the walls of the central passageway is disposed in fluid communication with the first tube and the second tube. The condenser has a vaporous-working fluid entrance port disposed in fluid communication with the vaporous-working fluid exit port of the evaporator and a liquid-working fluid exit port disposed in fluid communication with the liquid-working fluid entrance port of the evaporator so that a working fluid cycles; (i) through the two spaced-apart parallel evaporators, and (ii) between the condenser and the two tubes.

The use of water close to electronic equipment may constitute a risk of short circuiting and damage to the equipment. This poses a problem because no other safe cooling medium has sufficient specific heat.

The present invention seeks to provide a remedy.

Accordingly a first aspect of the present invention is directed to a rear door heat exchanger having a multiplicity of coolant conducting loops each connected at one end to a common inlet or upstream header of the exchanger and at its other end to a common outlet or downstream header of the exchanger, characterised in that respective nozzles having respective orifices are provided at the ends of the loops which are connected to the inlet header, each orifice having a diameter appropriate for receiving coolant as a liquid and changing it to a liquid/gas bi-phase coolant.

Because the effective coolant in such an exchanger is bi-phase, that is to say part gaseous and part liquid, the latent heat of the transition between the liquid and gaseous states of the coolant is used to compensate for the relatively low specific heat of the coolant in its liquid state. The nozzles ensure that coolant in the loops is bi-phase.

Preferably the headers are elongate and cylindrical, the diameter of the outlet header being larger than that of the inlet header to accommodate the creation of a bi-phase coolant at the connections between the loops and the common inlet header. More preferably, the ratio of the outlet header internal diameter to the inlet header internal diameter is in the range from 1.1 to 1.5, for example about 1.3 which is especially suitable if the coolant is R134a refrigerant (1,1,1,2-tetrafluoroethane).

Advantageously, the loops extend generally horizontally. This matches a horizontal orientation of the blades.

The headers preferably extend generally vertically, and if the door is hinged at one side to a generally vertical hinge, the headers are preferably on the hinge side of the door to reduce the amount of movement thereof when the door is opened and closed. This facilitates connection of the headers to a coolant circuit.

Advantageously the headers are provided at respective ends with respective quick release connectors, for example bayonet connectors.

The invention extends to a method of cooling air exiting a blade rack by means of a heat exchanger through which bi-phase coolant is passed.

Advantageously, the coolant is one which has a boiling point close to normal room temperature, for example in the range from 15°C to 25°C. This facilitates the bi-phase construction. For example the coolant may comprise R134a refrigerant (1,1,1,2-tetrafluoroethane).

Preferably such a method uses a heat exchanger according to the present invention and as set out in one or more of the preceding paragraphs.

An example of a rear door heat exchanger and a cooling unit made in accordance with the present invention will now be described in greater detail with reference to the accompanying drawings, in which:
- Figure 1: shows a perspective view from one side and from above of a data centre incorporating rear door heat exchangers, each of which embody the present invention;
- Figure 2: shows a rear elevational view of one of the rear door heat exchangers shown in Figure 1;
- Figure 3: shows a view from above of the rear door heat exchanger shown in Figure 2;
- Figure 4: shows a side view of the rear door heat exchanger shown in Figures 2 and 3;
- Figure 5: shows a view from the other side of the rear door heat exchanger shown in Figures 2 and 3;
- Figure 6: shows a view of the same side of the door as is shown in Figure 5 but with parts thereof removed to reveal other parts of the exchanger;
- Figure 7: shows an axial sectional view of parts of the rear door heat exchanger shown in Figures 1 to 6;
- Figure 8: is an electrical and fluid circuit diagram of apparatus embodying the second aspect of the present invention;
- Figure 9: shows a diagrammatic axial sectional view through a separator of the apparatus shown in Figure 8;
- Figure 10: shows the cross-section through a coil of the apparatus shown in Figure 8 when the latter is in use; and
- Figure 11: shows an explanatory graph.

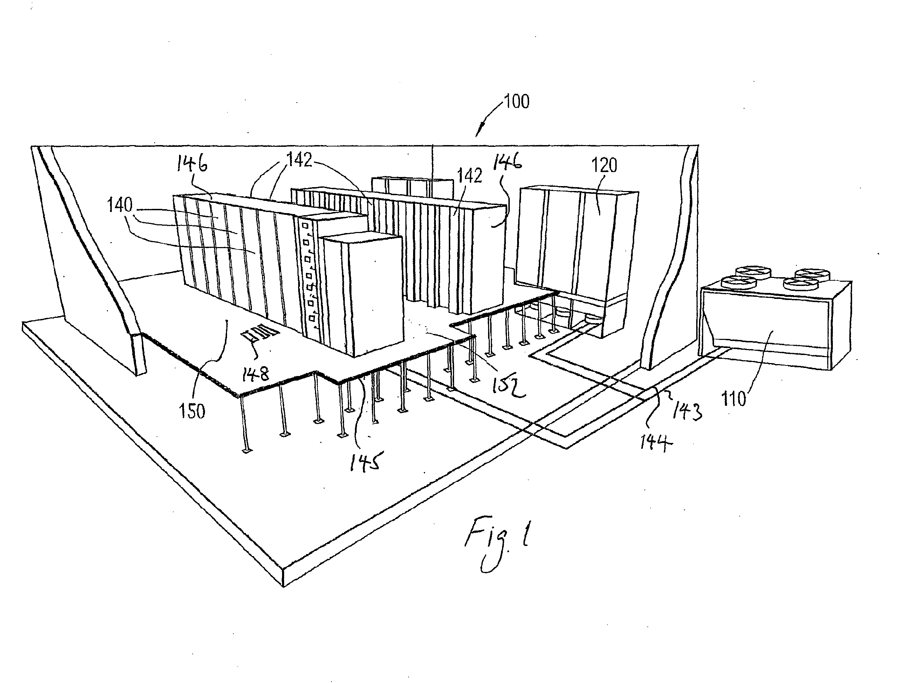

Figure 1 shows a data centre 100 provided with a chiller unit 110 connected to supply cooling water to perimeter cooling 120. The data centre 100 is provided with rows of blade racks 140, the blade racks 140 being provided with respective rear door heat exchangers 142. Chilled water from the chiller 110 is pumped through feed piping 143 to the perimeter cooling 120 and warm water returns from the perimeter cooling 120 to the chiller 110 through further piping 144.

The perimeter cooling 120, and the blade racks 140 with their rear door heat exchangers 142 rest on a raised floor 145. The blade racks 140 are arranged in rows 146. Air vents 148 are provided in the raised floor 145 in one or more aisles 150 between rows 146,with adjacent aisles 152 being without vents, so that aisles with vents alternate with those without. When the data centre 100 is in use, warm air in a warm aisle 152 rises upwardly and draws with it through the racks 140 cool air from the adjacent cool aisles 150. This creates a continual draft of cool air through the racks 140. The warm air rises towards the ceiling of the data centre and outwardly towards the perimeter cooling 120 where it is cooled and therefore falls downwardly to exit the perimeter cooling 120 underneath the raised flooring 145. This convection current continues with the cool air rising upwardly through the vents 148 to continue the air cooling cycle.

The rear door heat exchangers 142 provide additional cooling of the air flowing through the data centre 100, the cooling medium flowing through them being provided by a cooling unit 153.

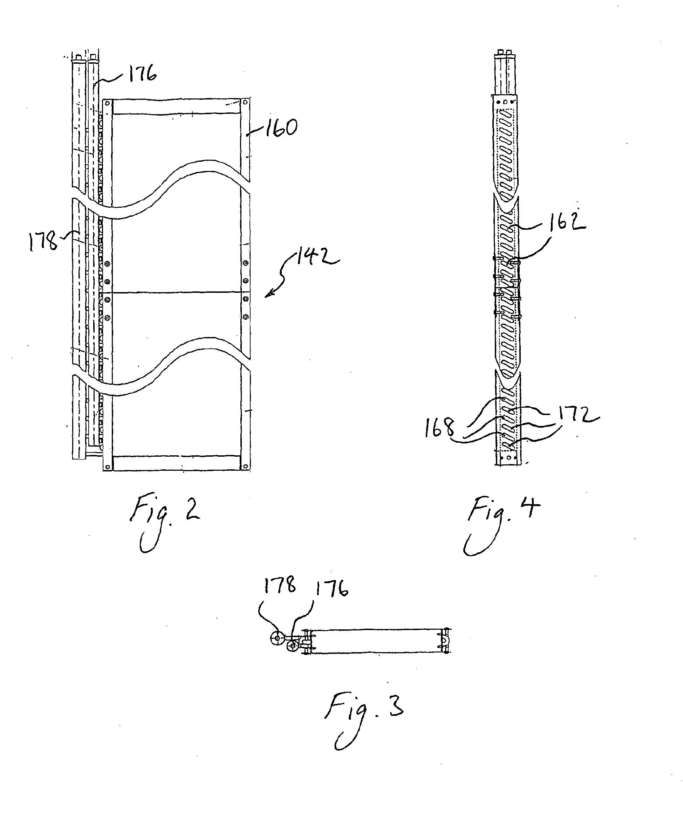

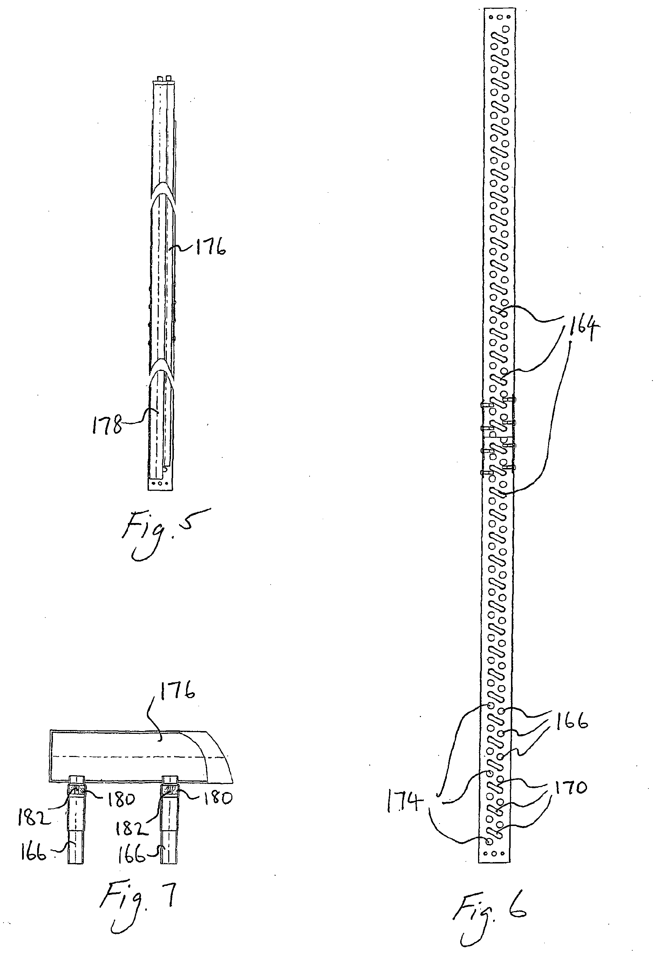

The construction of each rear door heat exchanger 142 is shown in greater detail in Figures 2 to 6. From these Figures it will be seen that the rear door heat exchanger 142 comprises a frame 160 supporting metal tubing 162. This tubing comprises a multiplicity of horizontally extending loops or coils 164. Each coil comprises an inlet 166 on one side of the frame 160 to a straight horizontal section of the loop or coil which extends through to the opposite side of the frame 160 where it bends on a slant through a 180° curve 168. From there it extends straight and horizontally back to the first side of the door where it passes through another slanting 180° bend 170 into a further straight horizontal section of the loop or coil to the other side of the door where it extends through a third slanting 180° bend 172 into a fourth straight horizontal section of the coil to the first side of the door, in which is located the inlet 166, to an outlet 174.

Each inlet 166 is in fluid communication with a generally vertically arranged cylindrical inlet header 176.

Each loop or coil outlet 174 is connected to a common vertically arranged cylindrical outlet header 178.

The ratio of the internal diameter of the outlet header to that of the inlet header is substantially 1.3. In the illustrated exchanger, the internal diameter of the outlet header is 35mm, and that of the inlet header is 28mm, giving a ratio of 1.25.

The connection from the inlet header 176 to the coil inlets 166 is via respective nozzles 180. Each nozzle 180 comprises an orifice 182 having a diameter appropriate for receiving coolant as a liquid and changing it to a liquid/gas bi-phase coolant. By comparison, the connection between each coil outlet 174 and the outlet header 178 does not have such a nozzle 180 so that the full width of the coil pipe is available for transfer of fluid to the outlet header 178, appropriate for the coolant being in a gaseous or a vaporized bi-phase state. In this fashion, the rear door heat exchanger illustrated in Figures 2 to 7 is constructed as a bi-phase coolant rear door heat exchanger.

The door is connected to an associated blade rack 140 by way of hinges (not shown) located on the same side of the door 142 as the inlet and outlet headers 176 and 178. This enables the rear door heat exchanger to be opened to provide access to the rear of the blade rack. When the rear door heat exchanger 142 is installed as shown in Figure 1, the inlet and outlet headers 176 and 178 are connected to a refrigerant unit by way of flexible tubing (not shown) which unit pumps cooled liquid coolant to the inlet header 176 and receives gaseous and/or vaporized coolant from the outlet header 178. The presence of the inlet and outlet headers 176 and 178 on the hinged side of the rear door heat exchanger 142 reduces the travel of the flexible tube connectors (not shown) to those headers when the rear door heat exchanger is opened or closed.

Numerous variations and modifications to the illustrated rear door heat exchanger may occur to the reader without taking the resulting construction outside the scope of the present invention. For example, each loop or coil may comprise more or fewer horizontal sections. Each horizontal coil section may be provided with one or more fins which themselves may be oriented horizontally.

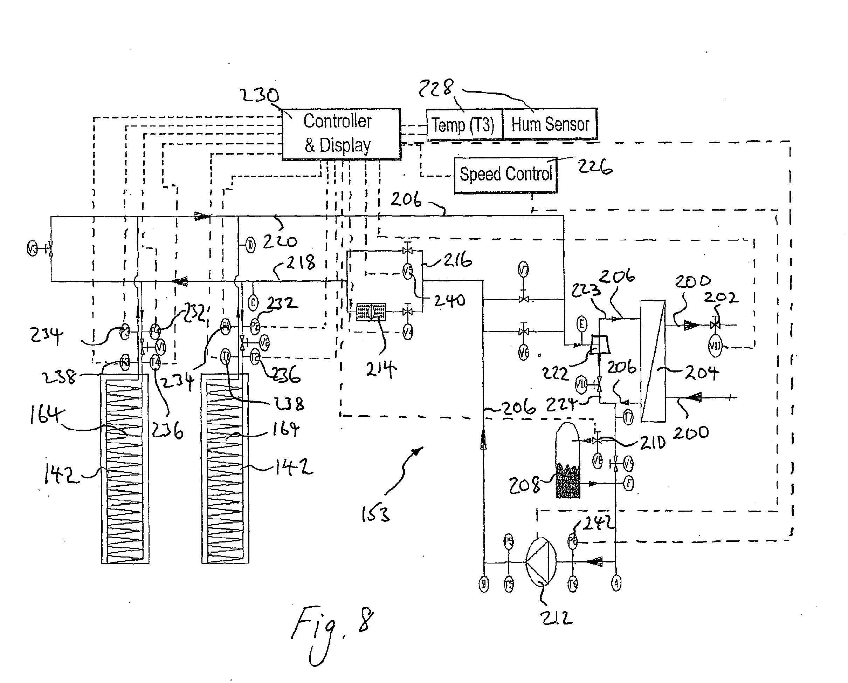

In the apparatus shown in Figure 8, the bi-phase rear door heat exchangers 142 shown in Figures 1 to 6 are also shown labeled 142. In addition, the cooling unit comprising the other parts of the apparatus shown in Figure 8 is labelled generally by the reference numeral 153. The latter comprises a first passageway 200 through which cooling water is passed when the apparatus is in use. A variable control valve 202 is connected in the passageway 200 to enable the flow of cooling water therethrough to be varied. Part of the passageway 200 is constituted by a part of a condenser 204. Another part of that condenser in thermal communication with the first-mentioned part thereof is a second passageway 206 through which flows refrigerant R134a (1,1,1,2-tetrafluoroethane).

Following the passageway 206 in a downstream direction from the condenser 204, there is provided a coolant reservoir 208 connected in parallel to that passageway. An input from the passageway 206 to the reservoir 208 is provided with a control valve 210.

Progressing further downstream along the passageway 206, there is provided a pump 212 provided to pump coolant around the said second passageway 206.

Further downstream of the passageway 206 there is provided a filter 214 connected in parallel with a part 216 of the passageway 206 which is in parallel with the filter 204 and bypasses the latter. Downstream from the filter 214 there is provided an input line 218 of the passageway 206 and output line 220 thereof.

Each bi-phase rear door heat exchanger 142 has an input connected to the input line 218 and an output connected to the output line 220 so that coolant in the passageway 206 passes through the coils 164 of the rear door heat exchangers 142 via their respective headers. Continuing downstream along the passageway 206 from the output line 220 thereof, the passageway connects to a separator 222 having a first branch line 223 which connects to the condenser 204 and a second branch line 224 which is in parallel with and bypasses the condenser 204.

A pump speed control 226 is electrically connected to control the pump 212. The cooling unit 153 is also provided with a temperature and humidity sensor or sensors 228 located within the data centre 100 to provide a measure of the temperature and humidity of the air in the data centre 100.

The unit 153 is also provided with a controller and display 230. The latter is connected to receive signals from respective pressure meters 232 connected to measure the pressure of coolant fluid in the inlets to the heat exchangers 142, from respective pressure meters 234 connected to measure the pressure of coolant in the outlets of the heat exchangers 142, from respective thermometers or temperature sensors 236 positioned to measure the temperature of coolant in the inlets to the heat exchangers 142, from respective thermometers or temperature sensors 238 to measure the temperature of coolant in the outlets of the heat exchangers 142, and also from the temperature and humidity sensor or sensors 228.

The controller and display 230 is also connected to control a variable valve 240 connected to control the flow of coolant through the part 216 of the second passageway 206. The controller and display 230 is also connected to control the variable control valve 210, the pump 212 and the variable control valve 202.

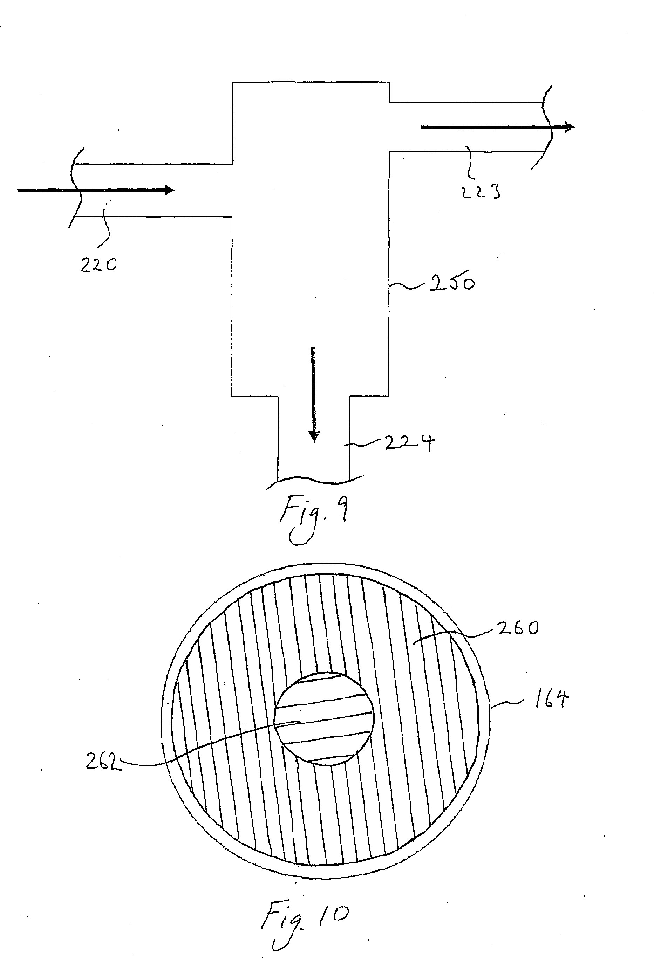

Further details of the separator are shown in Figure 9. Thus, it comprises a generally upright cylindrical chamber 250 having an internal cross-sectional area substantially greater than the internal cross-sectional areas of the passageways 220, 223 and 224. The passageway 224 extends downwardly from the lower end of the cylindrical chamber 250, the part 220 of the passageway 206 enters into an upper half of the cylindrical chamber 250, and the part 223 of the passageway 206 constitutes an outlet from the cylindrical chamber 250 at a position above the position at which the part 220 of the passageway 206 enters the cylindrical chamber 250.

The control unit 153 operate as follows.

With cooling water flowing through the first passageway 200, liquid coolant flows through the passageway 206 to the pump 212 which urges the fluid further along the passageway 206, either through the filter 214 or along the filter bypass 216 to the inlet line 218. From here coolant flows into the coils 164 of the rear door heat exchangers 142. The nozzles 180 thereof and the pressure of the coolant in the second passageway 206 are such as to cause a pressure drop across the nozzles 180 as to result in the coolant within the coils 164 of the rear door heat exchanger 142 being in a bi-phase state, partially liquid and partially gas.

Figure 10 shows a cross-section through a coil 164 which shows the coolant in contact with the inner surface of the coil 164 in liquid state 260 and in a central region of the coil 164 in a gaseous state 262. This bi-phase coolant is returned to the outlet line 220 at a pressure of about 5.2 bars ± 10%. The latter passes the coolant in the bi-phase state to the separator 222. Here the heavier liquid part of the coolant falls into the lower half of the cylindrical chamber 250 and the lighter gaseous part of the coolant rises into the uppermost part of the cylindrical chamber 250. The gaseous part of the coolant proceeds along that part 223 of the passageway 206 of the condenser 204 where it is condensed into liquid form so that it passes through an outlet of the condenser 204 where it joins the liquid part of the coolant which has descended through the part 224 of the passageway 206, before it returns to the pump 212. Thus, the cycle continues.

The controller and display 230 controls the speed control 226 which in turn controls the pump 212 to operate within a predetermined range of pump speeds. At the same time, in the event that the pressure sensor 242 issues signals to the controller and display 230 below a predetermined value, such as creates a risk of cavitation within the pump 212, the controller and display 230 is programmed to issue a signal to the speed control 226 to lower the speed of the pump 212.

In the event that the signals issued by the temperature and humidity sensor or sensors 228 and the temperature sensors 236 and 238 indicate that the temperature of the coolant within the coils 164 is unacceptably close to the dew point of the air in the date centre 100, the controller and display issues a signal to the valve 202 in the said first passageway 200 to reduce the available cross-sectional area through the valve 202 so as to reduce the flow rate of cooling water 200 through the condenser 204 so as to increase the pressure and the temperature of the coolant fluid in the said second passageway 206.

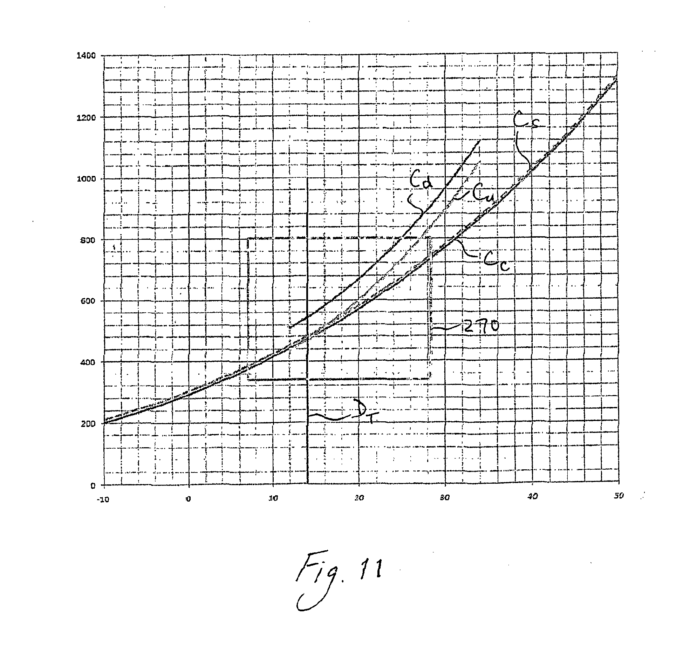

Figure 11 shows a representation of the relationships between different variables in the apparatus of Figure 8 and the data centre shown in Figure 1. In this graph, temperature in degrees centigrade is indicated along the horizontal axis and pressure in KPa is indicated along the vertical axis. Thus, the dew point within the centre 100 is represented by a vertical line D_{T} in Figure 11. The curve C_{c} shows the saturation curve of the coolant in the said second passageway, the dotted curve Cₛ shows the same curve with a safety margin factor built in to reduce the likelihood of condensation. The curve Cᵤ represents variation of system pressure as a function of the temperature of coolant immediately upstream of the pump 212, that is to say, on the suction side thereof, and C_{d} is the same curve for the downstream or higher pressure side thereof.

It can be seen therefore that the working region of the pump 212 must remain within the upper right-hand portion of the box 270.

## Claims

1. A rear door heat exchanger (142) having a multiplicity of coolant conducting loops (164) each connected at one end to a common inlet or upstream header (176) of the exchanger (142) and at its other end to a common outlet or downstream header (178) of the exchanger (142), **characterised in that** respective nozzles (180) having respective orifices (182) are provided at the ends of the loops (164) which are connected to the inlet header (176), each orifice (182) having a diameter appropriate for receiving coolant as a liquid and changing it to a liquid/gas bi-phase coolant.

2. A heat exchanger (142) according to claim 1, **characterised in that** the headers (176, 178) are elongate and cylindrical, the diameter of the outlet header (178) being larger than that of the inlet header (176) to accommodate the creation of a bi-phase coolant at the connections between the loops (164) and the common inlet header (176).

3. A heat exchanger (142) according to claim 2, **characterised in that** the ratio of the outlet header (178) internal diameter to the inlet header (176) internal diameter is about 1.3.

4. A heat exchanger (142) according to claim 3, **characterised in that** R134a refrigerant (1,1,1,2-tetrafluoroethane) in bi-phase state flows through it when it is in use.

5. A heat exchanger (142) according to any preceding claim, **characterised in that** the loops (164) extend generally horizontally.

6. A heat exchanger (142) according to any preceding claim, **characterised in that** the headers (176, 178) extend generally vertically.

7. A heat exchanger (142) according to any preceding claim, **characterised in that** it is adapted to be hinged at one side to a generally vertical hinge.

8. A heat exchanger (142) according to claim 7, **characterised in that** the headers (176, 178) are on the hinge side of the door to reduce the amount of movement thereof when the door is opened and closed.

9. A method of cooling air which has passed over heat-generating equipment using a rear door heat exchanger (142) through which bi-phase coolant is passed, in which coolant as a liquid is passed from a common upstream header (176) of the exchanger (142) into a multiplicity of coolant conduction loops (164) via respective nozzles (180) having orifices (182), each having a diameter appropriate to change the liquid into a liquid/gas bi-phase coolant, which passes through the loops (164) to a common outlet or downstream header (178) of the exchanger (142).

10. A method according to claim 9, **characterised in that** the coolant comprises R134a refrigerant (1,1,1,2-tetrafluoroethane).

## Patentansprüche

1. Rückwandtür-Wärmetauscher (142) mit einer Vielzahl von Kühlmittel-Leitungsschleifen (164), die jeweils an einem Ende mit einem gemeinsamen Eintritt oder vorgeschalteten Sammler (176) des Wärmetauschers (142) und an ihrem anderen Ende mit einem gemeinsamen Austritt oder nachgeschalteten Sammler (178) des Wärmetauschers (142) verbunden sind, **dadurch gekennzeichnet, dass** entsprechende Düsen (180) mit entsprechenden Öffnungen (182) an den Enden der Schleifen (164) vorgesehen sind, die mit dem Eintrittssammler (176) verbunden sind, wobei jede Öffnung (182) einen Durchmesser aufweist, der geeignet ist, ein Kühlmittel als Flüssigkeit aufzunehmen und es in ein Flüssigkeit-Gas-Zweiphasenkühlmittel umzuwandeln.

2. Wärmetauscher (142) nach Anspruch 1, **dadurch gekennzeichnet, dass** die Sammler (176, 178) länglich und zylinderförmig sind, wobei der Durchmesser des Austrittssammlers (178) größer ist als der des Eintrittssammlers (176), um der Bildung eines Zweiphasenkühlmittels an den Verbindungen zwischen den Schleifen (164) und dem gemeinsamen Eintrittssammler (176) Rechnung zu tragen.

3. Wärmetauscher (142) nach Anspruch 2, **dadurch gekennzeichnet, dass** das Verhältnis des Innendurchmessers des Austrittssammlers (178) zum Innendurchmesser des Eintrittssammlers (176) ungefähr 1,3 beträgt.

4. Wärmetauscher (142) nach Anspruch 3, **dadurch gekennzeichnet, dass** das Kältemittel R134a (1,1,1,2-Tetrafluorethan) im Zweiphasenzustand den Wärmetauscher durchströmt, wenn er im Einsatz ist.

5. Wärmetauscher (142) nach einem der vorstehenden Ansprüche, **dadurch gekennzeichnet, dass** sich die Schleifen (164) im Allgemeinen horizontal erstrecken.

6. Wärmetauscher (142) nach einem der vorstehenden Ansprüche, **dadurch gekennzeichnet, dass** sich die Sammler (176, 178) im Allgemeinen vertikal erstrecken.

7. Wärmetauscher (142) nach einem der vorstehenden Ansprüche, **dadurch gekennzeichnet, dass** er angepasst ist, um an einer Seite an ein im Allgemeinen vertikales Scharnier angelenkt zu werden.

8. Wärmetauscher (142) nach Anspruch 7, **dadurch gekennzeichnet, dass** sich die Sammler (176, 178) auf der Scharnierseite der Tür befinden, um deren Bewegungsumfang beim Öffnen und Schließen der Tür zu reduzieren.

9. Verfahren zur Kühlung von Luft, die über eine wärmeerzeugende Anlage hinweggeströmt ist, unter Verwendung eines Rückwandtür-Wärmetauschers (142), durch den ein Zweiphasenkühlmittel geleitet wird, wobei das Kühlmittel als Flüssigkeit von einem gemeinsamen vorgeschalteten Sammler (176) des Wärmetauschers (142) in eine Vielzahl von Kühlmittel-Leitungsschleifen (164) über entsprechende Düsen (180) mit Öffnungen (182) geleitet wird, welche jeweils einen Durchmesser aufweisen, der geeignet ist, die Flüssigkeit in ein Flüssigkeit-Gas-Zweiphasenkühlmittel umzuwandeln, das durch die Schleifen (164) zu einem gemeinsamen Austritt oder nachgeschalteten Sammler (178) des Wärmetauschers (142) fließt.

10. Verfahren nach Anspruch 9, **dadurch gekennzeichnet dass** das Kühlmittel das Kältemittel R134a (1,1,1,2-Tetrafluorethan) umfasst.

## Revendications

1. Échangeur de chaleur (142) à porte arrière ayant une multiplicité de boucles de conduction (164) de fluide de refroidissement, chacune connectée à une extrémité à une entrée commune ou collecteur d'entrée (176) de l'échangeur (142) et à son autre extrémité à une sortie commune ou collecteur de sortie (178) de l'échangeur (142), **caractérisé en ce que** des buses respectives (180) ayant des orifices respectifs (182) sont disposées aux extrémités des boucles (164) qui sont connectées au collecteur d'entrée (176), chaque orifice (182) ayant un diamètre approprié pour recevoir le liquide de refroidissement sous forme de liquide et le changer en un liquide de refroidissement biphasé liquide/gaz.

2. Échangeur de chaleur (142) selon la revendication 1, **caractérisé en ce que** les collecteurs (176, 178) sont allongés et cylindriques, le diamètre du collecteur de sortie (178) étant plus large que celui du collecteur d'entrée (176) pour permettre la création d'un liquide de refroidissement biphasé aux connexions entre les boucles (164) et le collecteur d'entrée commun (176).

3. Échangeur de chaleur (142) selon la revendication 2, **caractérisé en ce que** le ratio du diamètre intérieur du collecteur de sortie (178) sur le diamètre intérieur du collecteur d'entrée (176) est d'environ 1,3.

4. Échangeur de chaleur (142) selon la revendication 3, **caractérisé en ce que** le liquide réfrigérant R134a (1,1,1,2-tétrafluoroéthane) à l'état biphasé circule au travers de celui-ci lorsqu'il est en utilisation.

5. Échangeur de chaleur (142) selon l'une quelconque des revendications précédentes, **caractérisé en ce que** les boucles (164) s'étendent de façon générale horizontalement.

6. Échangeur de chaleur (142) selon l'une quelconque des revendications précédentes, **caractérisé en ce que** les collecteurs (176, 178) s'étendent généralement verticalement.

7. Échangeur de chaleur (142) selon l'une quelconque des revendications précédentes, **caractérisé en ce qu'**il est adapté pour être articulé d'un côté sur une charnière généralement verticale.

8. Échangeur de chaleur (142) selon la revendication 7, **caractérisé en ce que** les collecteurs (176, 178) sont sur le côté charnière de la porte pour réduire l'amplitude de leur mouvement lorsque la porte est ouverte et fermée.

9. Méthode de refroidissement de l'air qui est passé sur un équipement générant de la chaleur, utilisant un échangeur thermique à porte arrière (142) au travers duquel un liquide de refroidissement biphasé passe, dans lequel le liquide de refroidissement sous forme liquide est envoyé d'un collecteur d'entrée commun (176) de l'échangeur (142) dans une multiplicité de boucles de conduction (164) de liquide de refroidissement via des buses respectives (180) ayant des orifices (182), chacune ayant un diamètre approprié pour changer le liquide en un liquide de refroidissement biphasé liquide/gaz, qui passe au travers des boucles (164) vers une sortie commune collecteur de sortie (178) de l'échangeur (142).

10. Méthode selon la revendication 9, **caractérisée en ce que** le liquide de refroidissement comprend le liquide réfrigérant R134a (1,1,1,2-tétrafluoroéthane).
